# EUROPÄISCHE PATENTSCHRIFT

(11) **EP 3 471 516 B1**
(45) Veröffentlichungstag und Bekanntmachung des Hinweises auf die Patenterteilung: **04.03.2026**
(21) Anmeldenummer: 18199267.8
(22) Anmeldetag: 09.10.2018
(51) Int. Cl.: H05H 7/02, H01P 5/12

(54) **HOCHFREQUENZ-VERSTÄRKER-EINHEIT MIT AUF AUSSENLEITER ANGEORDNETEN VERSTÄRKERMODULEN**
HIGH FREQUENCY AMPLIFIER UNIT WITH AMPLIFIER MODULES DISPOSED ON AN OUTER CONDUCTOR
UNITÉ AMPLIFICATEUR HAUTE FRÉQUENCE POURVU DE MODULES AMPLIFICATEURS DISPOSÉS SUR UN CONDUCTEUR EXTÉRIEUR

(30) Priorität: 09.10.2017 DE 102017123377
(43) Veröffentlichungstag der Anmeldung: 17.04.2019
(73) Patentinhaber: Cryoelectra GmbH, 42287 Wuppertal (DE)
(72) Erfinder: PIEL, Dr. Helmut, 42287 Wuppertal (DE); KOLESOV, Dr. Ing. Sergei, 58285 Gevelsberg (DE); PUPETER, Dr. Nico, 42111 Wuppertal (DE)
(74) Vertreter: Cohausz & Florack

(56) Entgegenhaltungen:
- DE-A1- 102009 046 463
- A.JAIN ET AL: "Design of High Power Radio Frequency Radial Combiner for Proton Accelerator", REV.SCI.INSTRUM. 80, 016106 (2009), 26 January 2009 (2009-01-26), pages 1 - 3, XP002789445, DOI: 10.1063/1.5022056
- A.JAIN ET AL: "High Power Solid state RF Amplifier for Proton Accelerator", REV.SCI.INSTR.79, 014702 (2008), 15 January 2008 (2008-01-15), pages 1 - 7, XP002789446, DOI: 10.1063/1.2829154
- FATHY A E ET AL: "a Simplified Design Approach for Radial Power Combiners", IEEE TRANSACTIONS ON MICROWAVE THEORY AND TECHNIQUES, PLENUM, USA, vol. 54, no. 1, 1 January 2006 (2006-01-01), pages 247 - 255, XP001545173, ISSN: 0018-9480, DOI: 10.1109/TMTT.2005.860302

## Beschreibung

Die vorliegende Erfindung betrifft eine Hochfrequenz(HF)-Verstärker-Einheit umfassend mehrere Verstärkermodule zum Verstärken von Hochfrequenzeingangssignalen zu Hochfrequenzausgangssignalen und einen Koaxial-Combiner mit einem Außenleiter und einem hierzu koaxial angeordneten Innenleiter zum Zusammenführen der Hochfrequenzausgangssignale der Verstärkermodule. Zudem betrifft die Erfindung ein Verstärker-System.

Beschleunigungsresonatoren, insbesondere supraleitende Cavities von Teilchenbeschleunigern sind bestimmt durch die Bauart des Beschleunigers (Zyklotron, Linearbeschleuniger und Synchrotron) und durch die Art der zu beschleunigenden Teilchen. Allen Resonatoren ist gemeinsam, dass sie mit hohen HF-Leistungen versorgt werden müssen, um die nötigen Beschleunigungsfeldstärken und den gewünschten Energiegewinn der zu beschleunigenden Teilchen zu gewährleisten. Die in jüngster Zeit entwickelten transistorbasierten Verstärkermodule ermöglichen eine Ausgangsleistung von bis zu 500 W pro Verstärkermodul und teilweise sogar darüber hinaus.

Selbst in kleinen Beschleunigern werden bereits HF-Leistungen von deutlich mehr als 10kW zum Betrieb des Beschleunigers und insbesondere des Beschleunigungsresonators benötigt. In großen Zyklotrons oder in den Beschleunigungsresonatoren von Synchrotrons und Speicherringen werden HF-Leistungen von bis zu 100kW und mehr gefordert. Die Ausgangsleistung von dutzenden Verstärkermodulen (Amplifier Units) muss demnach zum Betrieb kombiniert, das heißt zusammengeführt bzw. aufsummiert werden. Hierzu werden die durch die Verstärkermodule verstärkten Hochfrequenzausgangssignale mittels Koaxialkabeln zu sogenannten HF-Leistungs-Combinern geführt, welche die verstärkten Hochfrequenzausgangssignale zusammenführen. Dabei wird in der Hochfrequenztechnik unter einem Combiner eine Baugruppe verstanden, welche mehrere schwächere Signale (in der Regel gleicher Frequenz) zu einem stärkeren Signal zusammenfügt. Gleichzeitig isoliert er in der Regel die Eingänge voneinander, so dass diese sich nicht gegenseitig beeinflussen, beziehungsweise die jeweils anderen Signalerzeuger.

Problematisch ist zum einen, dass die Verstärkereinheiten dabei in der Regel erhebliche Abwärme erzeugen, welche abzuführen ist. Durch diese Anforderungen wird das mögliche Design sowohl der einzelnen Hochfrequenz-Verstärker-Einheit als auch des gesamten Verstärker-Systems eingeschränkt und führt bei hohen Leistungen zu entsprechend raumfüllenden Anlagen. Hinzu kommt zum anderen, dass dieses Vorgehen mit wachsender Frequenz der verstärkten zu kombinierenden Hochfrequenzausgangssignale wegen der stark zunehmenden jouleschen Verluste in den Koaxialkabeln zunehmend unattraktiv wird.

Aus dem Artikel "Design of high power radio frequency radial combiner for proton accelerator", Akhilesh Jain et al., rev.sci.instrum. 80, 016106 (2009), 1-3, ist ein scheibenförmiger Radial-Combiner bekannt, an den über 50-Ohm Koaxial-Zuführleitungen die Verstärkermodule sternförmig angeschlossen werden. Im Zentrum des scheibenförmigen Radial-Combiners wird die Leistung über einen senkrecht hierauf stehenden Hohlleiter ausgekoppelt.

Aus dem Artikel "High power solid state rf amplifier for proton accelerator", Akhilesh Jain et al., rev.sci.instrum. 79, 014702 (2008), 1-7, ist ein vergleichbarer Radial-Combiner bekannt.

Wichtige Anforderungen an eine Hochfrequenz-Verstärker-Einheit mit einem Leistungs-Combiner sind daher
1. eine hohe Wirtschaftlichkeit (möglichst geringe Investitions- und Betriebskosten),
2. möglichst geringe Zuleitungsverluste (Kabel) und Kombinationsverluste und damit ein hoher Wirkungsgrad,
3. eine kompakte Bauform und
4. eine leichte Zugänglichkeit und Austauschbarkeit der Hochfrequenz-Verstärker-Einheiten und/oder Verstärkermodule.

Die vorliegende Erfindung hat sich daher die Aufgabe gestellt, eine Hochfrequenz-Verstärker-Einheit und ein Verstärker-System bereitzustellen, die einige oder alle dieser Anforderungen erfüllt.

Gemäß einem ersten Aspekt der Erfindung wird die Aufgabe bei einer Hochfrequenz-Verstärker-Einheit umfassend mehrere Verstärkermodule zum Verstärken von Hochfrequenzeingangssignalen zu Hochfrequenzausgangssignalen und einen Koaxial-Combiner mit einem Außenleiter und einem hierzu koaxial angeordneten Innenleiter zum Zusammenführen der Hochfrequenzausgangssignale der Verstärkermodule durch die Merkmale des Anspruchs 1 gelöst. Hierbei sind die Verstärkermodule außenseitig auf dem Außenleiter des Koaxial-Combiners angeordnet und die Verstärkermodule zur Übertragung der Hochfrequenzausgangssignale auf den Koaxial-Combiner mit dem koaxialen Innenleiter des Koaxial-Combiners verbunden.

Dadurch, dass die Verstärkermodule einerseits außenseitig auf dem Außenleiter des Koaxial-Combiners angeordnet sind und gleichzeitig die Verstärkermodule zur Übertragung der Hochfrequenzausgangssignale auf den Koaxial-Combiner mit dem koaxialen Innenleiter des Koaxial-Combiners verbunden sind, kann insbesondere im Vergleich zu einem Hohlleiter (ohne Innenleiter) eine äußerst platzsparende Hochfrequenz-Verstärker-Einheit in kompakter Bauform realisiert werden. Die Übertragung der (verstärkten) Hochfrequenzausgangssignale, das heißt die Leistungsübertragung von den Verstärkermodulen auf den Koaxial-Combiner kann aufgrund der Anordnung der Verstärkermodule auf dem Außenleiter des Koaxial-Combiners kabelfrei erfolgen. Aufgrund der nicht benötigten Kabel zwischen den Verstärkermodulen und dem Koaxial-Combiner unterliegt die Hochfrequenz-Verstärker-Einheit nur geringen Kombinationsverlusten und ist im Bedarfsfall schnell zugänglich. Es hat sich insbesondere gezeigt, dass die Ausgangsleistung der Verstärkermodule durch eine Verbindung mit dem Innenleiter des Koaxial-Combiners direkt auf dem Koaxial-Combiner übertragen und dabei der Außenleiter des Koaxial-Combiners gleichzeitig vorteilhaft zur Kühlung der Verstärkermodule eingesetzt werden kann.

Bei den Hochfrequenzsignalen handelt es sich vorliegend vorzugsweise um Signale mit Frequenzen im Radiowellen und insbesondere Mikrowellen-Bereich. Das heißt, dass es sich bevorzugt um Wellen mit einer Frequenz von mindestens 50 MHz, vorzugsweise mindestens 70 MHz, weiter vorzugsweise mindestens 100 MHz und besonders bevorzugt mindestens 300 MHz handelt. Ebenfalls ist es bevorzugt, wenn es sich um Wellen mit einer Frequenz von höchstens 300 GHz, vorzugsweise höchstens 3 GHz handelt. Ein bevorzugter Bereich ist beispielsweise 1 bis 3 GHz. Eine typische Frequenz für den Anwendungsfall von Teilchenbeschleunigern liegt beispielsweise zwischen etwa 70 MHz und 3 GHz (zum Beispiel bei 1,3 GHz, 1,5 GHz oder 1,75 GHz). Dementsprechend handelt es sich vorzugsweise um Hochfrequenz-Verstärker-Einheiten, Verstärkermodule und Koaxial-Combiner, die zur Erzeugung, Verstärkung bzw. Führung von derartigen Mikrowellen ausgelegt sind. Die Energie der Signale wird dabei in dem Dielektrikum (hier vorzugsweise Luft) zwischen Außenleiter und Innenleiter transportiert.

Ein Verstärkermodul umfasst insbesondere einen Transistorverstärker, welcher beispielsweise einen oder mehr Leistungstransistoren umfassen kann, bei Gegentaktbetrieb beispielsweise zwei Leistungstransistoren. Weiterhin kann ein Verstärkermodul einen Zirkulator umfassen, welcher dem Schutz des oder der vorgelagerten Transistoren dient. Ein Verstärkermodul kann beispielsweise als Platine oder Palette ausgebildet sein, welche einstückig sein kann, aber beispielsweise auch eine Transistorplatine und eine Zirkulatorplatine umfassen kann. Ein Verstärkermodul liefert vorzugsweise eine (nominale) Leistung von mindestens 300 W, bevorzugt mindestens 400 W, weiter bevorzugt mindestens oder mehr als 500 W. Ein Verstärkermodul weist auf der dem Koaxial-Combiner zugewandten Seite (insbesondere Montageseite oder Unterseite) eine Metallschicht, insbesondere aus Kupfer oder Aluminium auf.

Die Hochfrequenz-Verstärker-Einheit kann weiterhin einen (oder mehrere) Treiber, einen (oder mehrere) Vorverstärker und/oder einen Splitter, welcher der Aufteilung der Signale in mehrere Hochfrequenzeingangssignale für mehrere Verstärkermodule dient, umfassen. Derartige Komponenten können wie die Verstärkermodule ebenfalls außenseitig auf dem Koaxial-Combiner angeordnet sein oder Teil hiervon sein. Alternativ können derartige Komponenten aber auch separat angeordnet sein, insbesondere wenn die Verstärkermodule bereits im Wesentlichen den gesamten Platz auf dem Außenleiter des Koaxial-Combiner einnehmen. Bevorzugt umfasst eine Hochfrequenz-Verstärker-Einheit zumindest vier, bevorzugt zumindest sechs, weiter bevorzugt zumindest acht Verstärkermodule.

Es hat sich als vorteilhaft herausgestellt, wenn der Koaxial-Combiner sich vorzugsweise in eine Längsrichtung erstreckt und insofern eine turmartige Geometrie mit sich in Längsrichtung erstreckenden (und durch den Außenleiter gebildeten) Seitenflächen aufweist. Der Koaxial-Combiner, insbesondere der Außenleiter und der koaxiale Innenleiter, ist/sind vorzugsweise aus Metall, insbesondere aus Kupfer und/oder Aluminium hergestellt.

Darunter, dass die Verstärkermodule jeweils mit dem koaxialen Innenleiter verbunden sind, wird insbesondere verstanden, dass der Ausgang des Verstärkermoduls (beispielsweise ein Koppelkreis des Verstärkermoduls) elektrisch mit dem Innenleiter verbunden ist. Die Verbindung kann beispielsweise über elektrisch leitfähige Koppelstifte erfolgen. Auf diese Weise sind die Verstärkermodule dann insbesondere an einem eingangsseitigen Ende des koaxialen Innenleiters mit dem koaxialen Innenleiter verbunden. Das Auskoppeln der Leistung aus der Hochfrequenz-Verstärker-Einheit erfolgt dann beispielsweise über ein ausgangsseitiges Ende des koaxialen Innenleiters, beispielsweise indem der koaxiale Innenleiter ausgangsseitig über den Außenleiter hinausragt und beispielsweise als Sonde (insbesondere als (Stab-)Antenne) zum Einkoppeln in einen Wellenleiter dient.

Gemäß einer Ausgestaltung der Hochfrequenz-Verstärker-Einheit verläuft der Koaxial-Combiner in eine Längsrichtung und der Außenleiter ist außenseitig im Querschnitt mehreckig, insbesondere viereckig ausgebildet. Auf diese Weise kann der Koaxial-Combiner bzw. Außenleiter des Koaxial-Combiners auf einfache Weise außenseitig Außen- oder Seitenflächen bilden, die als Montageflächen für die Verstärkermodule dienen können. Es hat sich gezeigt, dass auf diese Weise eine äußerst kompakte Bauform und Anordnung der Hochfrequenz-Verstärker-Einheiten auf weiteren Combinern bei ausreichender Kühlung und geringen Kombinationsverlusten erreicht werden kann.

Bevorzugt weist nur die Außenseite des Außenleiters eine entsprechende Geometrie im Querschnitt auf, während die Innenseite des Außenleiters und/oder die Außenseite des Innenleiters im Querschnitt eine abweichende, insbesondere im Querschnitt runde Geometrie aufweisen. Es ist aber auch möglich, dass nicht nur der Außenleiter außenseitig, sondern zudem der Außenleiter innenseitig und/oder der Innenleiter außenseitig eine entsprechende oder abweichende mehreckige Geometrie im Querschnitt aufweisen.

In einem Beispiel können bei einer im Querschnitt n-eckigen Geometrie (und damit n Seiten) bevorzugt n Verstärkermodule auf der Außenfläche des Außenleiters des Koaxial-Combiners (auf jeder Seitenfläche eines) angeordnet werden. Ist der Koaxial-Combiner bzw. Außenleiter in Längsrichtung ausreichend lang, können in Längsrichtung pro Seitenfläche beispielsweise auch zwei Verstärkermodule angeordnet werden, sodass insgesamt sogar 2n Verstärkermodule auf der Außenfläche des Außenleiters des Koaxial-Combiners angeordnet werden können.

Die Verstärkermodule sind erfindungsgemäß im Wesentlichen flächig ausgebildet und im Wesentlichen flächig auf dem Außenleiter des Koaxial-Combiners angeordnet. Vorzugsweise decken die Verstärkermodule die Außenseite des Außenleiters im Wesentlichen ab. Wie bereits ausgeführt, ist auf jeder Seitenfläche in Umfangsrichtung gesehen vorzugsweise zumindest ein Verstärkermodul angeordnet.

Die Verstärkermodule sind erfindungsgemäß derart außenseitig auf dem Koaxial-Combiner angeordnet, dass der Außenleiter des Koaxial-Combiners zur Kühlung der Verstärkermodule dienen kann. Auf diese Weise kann eine insbesondere aktive Kühlung der Verstärkermodule bei geringem Platzbedarf erfolgen. Bisherige Ansätze im Stand der Technik sahen
hingegen vor, eine mittige Kühlplatine vorzusehen, auf die zur Platzeinsparung beidseitig Verstärkerplatinen aufgebracht waren. Da zwischen den Verstärkermodulen dann jedoch die Kühleinrichtung vorgesehen war, musste die Ausgangsleistung oberseitig mittels Koaxialkabeln abgeführt werden. Gemäß der beschriebenen Ausgestaltung ist sowohl die Wärme- als auch die Leistungsabgabe modulunterseitig an den Koaxial-Combiner insbesondere ohne dazwischen angeordnete zusätzliche, separate Kühleinrichtung möglich. Hierzu sind die Verstärkermodule insbesondere unmittelbar auf dem Außenleiter des Koaxial-Combiners angeordnet.

Dabei erfolgt die Kühlung der Verstärkermodule vorzugsweise ausschließlich (abgesehen von einer nicht zu verhindernden langsamen Wärmeübertragung durch das Verstärkermodul und die Umgebungsluft selbst) durch den Außenleiter des Koaxial-Combiners.

Zur Erzielung einer hohen Kühleffizienz und damit hohen Ausgangsleistungen ist gemäß einer bevorzugten Ausgestaltung der Hochfrequenz-Verstärker-Einheit der Außenleiter des Koaxial-Combiners zur Kühlung der Verstärkermodule als Teil eines Kühlmittelkreislaufs ausgebildet. Als Kühlmittel ist dabei beispielsweise Wasser (beispielsweise demineralisiertes Wasser) vorgesehen. Hierzu weist der Koaxial-Combiner beispielsweise zumindest einen Kühlmitteleingang und zumindest einen Kühlmittelausgang auf. Vorzugsweise weist der Außenleiter des Koaxial-Combiners integral (insbesondere im Bereich der Ecken) zumindest abschnittsweise in Längsrichtung verlaufende Kühlmittelleitungen (beispielsweise Bohrungen) auf.

Um die Kühlleistung und Ausgangsleistung der Hochfrequenz-Verstärker-Einheit weiterhin zu optimieren, sind gemäß einer bevorzugten Ausgestaltung der Hochfrequenz-Verstärker-Einheit die Verstärkermodule umlaufend auf dem Außenleiter des Koaxial-Combiners angeordnet. Wie bereits ausgeführt, ist dabei vorzugsweise auf jeder durch den Außenleiter bereitgestellten Seitenfläche in Umfangsrichtung gesehen (zumindest) ein Verstärkermodul angeordnet. Mit anderen Worten reihen sich in Umfangsrichtung gesehen die Verstärkermodule aneinander.

Gemäß einer bevorzugten Ausgestaltung der Hochfrequenz-Verstärker-Einheit ist zumindest ein Teil der Verstärkermodule in Längsrichtung gesehen auf gleicher Höhe mit dem koaxialen Innenleiter verbunden. Hierdurch ergibt sich eine möglichst einfache Geometrie des Koaxial-Combiners und insbesondere des koaxialen Innenleiters bei möglichst geringen Verlusten beim Übertragen der Hochfrequenzausgangssignale auf den Koaxial-Combiner. Die elektrischen Verbindungen (beispielsweise die Koppelstifte) zur Anbindung der entsprechenden Verstärkermodule verlaufen dann in einer Ebene, insbesondere senkrecht zur Längsrichtung des Koaxial-Combiners. Allerdings könne auch verschiedene Gruppen von Verstärkermodulen vorgesehen sein, wobei die Verstärkermodule einer Gruppe zwar auf gleicher Höhe mit dem koaxialen Innenleiter verbunden sind, die Verstärkermodule unterschiedlicher Gruppen aber auf unterschiedlichen Höhen, wie nachfolgend noch näher beschrieben.

Gemäß einer bevorzugten Ausgestaltung der Hochfrequenz-Verstärker-Einheit sind Verstärkermodule einer ersten Gruppe von Verstärkermodulen in einem ersten Längsabschnitt des Koaxial-Combiners außenseitig auf dem Außenleiter des Koaxial-Combiners angeordnet und Verstärkermodule einer zweite Gruppe von Verstärkermodulen in einem zweiten Längsabschnitt des Koaxial-Combiners außenseitig auf dem Außenleiter des Koaxial-Combiners angeordnet. Es hat sich gezeigt, dass trotz der in Längsrichtung versetzten Verstärkermodule eine Übertragung der Hochfrequenzausgangssignale mit hohem Wirkungsgrad auf den Koaxial-Combiner erreicht werden kann und auf diese Weise die Ausgangsleistung einer Hochfrequenz-Verstärker-Einheit letztendlich vordoppelt werden kann.

Der erste Längsabschnitt schließt sich dabei vorzugsweise unmittelbar an den zweiten Längsabschnitt an. Vorzugsweise wird dabei die Ausgangsleistung aller Verstärkermodule der Hochfrequenz-Verstärker-Einheit wie bereits beschrieben weiterhin über ein ausgangsseitiges Ende des koaxialen Innenleiters (beispielsweise in einen Wellenleiter) ausgekoppelt, welches in diesem Fall an einem dem zweiten Längsabschnitt abgewandten Endbereich des ersten Längsabschnitts liegt.

Gemäß einer bevorzugten Ausgestaltung der Hochfrequenz-Verstärker-Einheit sind die Verstärkermodule der ersten Gruppe an einem dem zweiten Längsabschnitt des Koaxial-Combiners zugewandten Endbereich des ersten Längsabschnitts des Koaxial-Combiners mit dem koaxialen Innenleiter verbunden und/oder sind die Verstärkermodule der zweiten Gruppe an einem dem ersten Längsabschnitt des Koaxial-Combiners zugewandten Endbereich des zweiten Längsabschnitts des Koaxial-Combiners mit dem koaxialen Innenleiter verbunden.

Dies hat den Vorteil, dass die Verbindungen der Verstärkermodule mit dem Innenleiter des Koaxial-Combiners in geometrischer Hinsicht sehr nahe beieinander liegen, was die Kombinationsverluste bei geringer Komplexität der Geometrie des Koaxial-Combiners gering hält. Dabei wurde erkannt, dass die Verbindungen der Verstärkermodule mit dem Innenleiter des Koaxial-Combiners (und damit die Übertragung der Hochfrequenzausgangssignale auf den Koaxial-Combiner) nicht notwendigerweise alle exakt auf der gleichen Höhe (in Längsrichtung gesehen) erfolgen müssen, was die in Längsrichtung versetzte Anordnung der Verstärkermodule ermöglicht. Der erste und der zweite Längsabschnitte sind dabei vorzugsweise im Wesentlichen gleich lang.

Um eine Anbindung der zweiten Gruppe von Verstärkermodulen (und damit eine verdoppelte Ausgangsleistung) bei möglichst geringen Kombinationsverlusten und kompakter Bauform zu erreichen, hat sich gemäß einer bevorzugten Ausgestaltung der Hochfrequenz-Verstärker-Einheit als vorteilhaft herausgestellt, wenn sich der koaxiale Innenleiter in den dem ersten Längsabschnitt des Koaxial-Combiners zugewandten Endbereich des zweiten Längsabschnitts des Koaxial-Combiners erstreckt. Der zweite Längsabschnitt des Koaxial-Combiners weist bei Bedarf einen Abschluss (beispielsweise gebildet durch eine zum Innenleiter beabstandete Leiterplatte oder einen im Bereich des zweiten Längsabschnitts im Innenbereich massiv ausgeführten Außenleiter) auf, welcher eine Ausbreitung der zusammengeführten Hochfrequenzausgangssignale vom Verbindungsbereich zwischen Verstärkermodulen und Innenleiter (Koppelbereich) in Richtung des zweiten Längsabschnitts unterbindet.

Gemäß einer bevorzugten Ausgestaltung der Hochfrequenz-Verstärker-Einheit sind die Verstärkermodule der ersten Gruppe und die Verstärkermodule der zweiten Gruppe in Längsrichtung des Koaxial-Combiners gesehen jeweils auf gleicher Höhe mit dem koaxialen Innenleiter verbunden. Mit anderen Worten sind die Verstärkermodule der ersten Gruppe in Längsrichtung des Koaxial-Combiners gesehen auf einer ersten Höhe mit dem koaxialen Innenleiter verbunden und die Verstärkermodule der zweiten Gruppe in Längsrichtung des Koaxial-Combiners gesehen auf einer zweiten Höhe mit dem koaxialen Innenleiter verbunden.

Um unerwünschte Reflexionen der Hochleistungsausgangssignale und damit Kombinationsverlust zu reduzieren oder weitestgehend zu vermeiden weist gemäß einer bevorzugten Ausgestaltung der Hochfrequenz-Verstärker-Einheit der Koaxial-Combiner einen Transformatorabschnitt mit einem Transformationsverhalten auf, sodass der (insbesondere durch die verbundenen Verstärkermodule verursachte) eingangsseitige Wellenwiderstand am Koaxial-Combiner auf einen ausgangsseitigen Wellenwiderstand am Koaxial-Combiner transformiert wird. Im Ergebnis wird im Rahmen einer Leitungstransformation der eingangsseitige Wellenwiderstand (im Bereich der Verbindung des koaxialen Innenleiters mit den Verstärkermodulen) auf einen abweichenden ausgangsseitigen Wellenwiderstand transformiert. So beträgt der eingangsseitige Wellenwiderstand des Koaxial-Combiners bei N Verstärkermodulen (dessen Leitungen typischerweise einen Wellenwiederstand von R₁ = 50 Ohm aufweisen) aufgrund der Zusammenführung (was als Parallelschaltung angesehen werden kann) nur noch etwa R/N. Um die Leitung auf einen gewünschten Wellenwiderstand R₂ (typischerweise wieder auf den ursprünglichen Wellenwiderstand R₁) zu transformieren, kann als Transformatorabschnitt beispielsweise ein λ/4-Transformator oder ein als λ/4-Transformator wirkender Transformator vorgesehen werden, dessen Länge in etwa (aber nicht notwendigerweise exakt) ein Viertel der Wellenlänge λ der Hochfrequenzsignale beträgt. So kann beispielsweise der Transformatorabschnitt auch im "Stepped Impedance"-Design mit sich stufig ändernden Durchmessern von Innen und/oder Außenleiter vorgesehen werden, sodass die Länge des Transformatorabschnitts deutlich kürzer als λ/4 wird. Der Wellenwiderstand des Transformtorabschnitts R_{T} kann mit (R₁/N * R₂)^{1/2} abgeschätzt werden. Ist beispielsweise N = 4 und R₁ = R₂ = 50 Ohm, ergibt sich ein Wellenwiderstand für den Transformatorabschnitt von etwa R_{T} = 25 Ohm. Die Werte R₁ und/oder R₂ müssen jedoch nicht zwangsweise 50 Ohm betragen.

Als eine vorteilhafte Geometrie des Koaxial-Combiners hat sich herausgestellt, wenn gemäß einer bevorzugten Ausgestaltung der Hochfrequenz-Verstärker-Einheit in dem Transformatorabschnitt der koaxiale Innenleiter des Koaxial-Combiners einen ersten Außendurchmesser und der Außenleiter des Koaxial-Combiners einen ersten Innendurchmesser aufweist und in einem sich an den Transformatorabschnitt anschließenden Ausgangsabschnitt der koaxiale Innenleiter des Koaxial-Combiners einen zweiten Außendurchmesser und/oder der Außenleiter des Koaxial-Combiners einen zweiten Innendurchmesser aufweist. Dabei ist der Außendurchmesser des koaxialen Innenleiters im Ausgangsabschnitt vorzugsweise kleiner als der Außendurchmesser des koaxialen Innenleiters im Transformatorabschnitt. Alternativ oder zusätzlich ist der Innendurchmesser des Außenleiters im Ausgangsabschnitt vorzugsweise kleiner als der Innendurchmesser des Außenleiters im Transformatorabschnitt. Es ist dabei aber fertigungstechnisch vorteilhaft, wenn sich entweder nur der Außendurchmesser des koaxialen Innenleiters von einem ersten zu einem abweichenden (kleineren) zweiten Außendurchmesser ändert oder wenn sich nur der Innendurchmesser des Außenleiters des Koaxial-Combiners von einem ersten zu einem abweichenden (kleineren) zweiten Innendurchmesser ändert und der jeweils andere Durchmesser gleich bleibt. Das heißt, dass der zweite Innendurchmesser bzw. Außendurchmesser auch gleich dem ersten Innendurchmesser bzw. Außendurchmesser sein kann.

Um unerwünschte Reflexionen der Hochleistungsausgangssignale und damit Kombinationsverlust zu reduzieren oder weitestgehend zu vermeiden, ist gemäß einer bevorzugten Ausgestaltung der Hochfrequenz-Verstärker-Einheit das Verhältnis des ersten Innendurchmessers des Außenleiters zum ersten Außendurchmesser des Innenleiters im Transformatorabschnitt kleiner als das Verhältnis des zweiten Innendurchmessers des Außenleiters zum zweiten Außendurchmesser des Innenleiters im Ausgangsabschnitt. Da der Wellenwiderstand von dem Verhältnis des Innendurchmessers des Außenleiters und dem Außendurchmesser des Innenleiters abhängt, kann auf diese Weise eine Leitungstransformation erfolgen. Beispielsweise ist das Verhältnis des Innendurchmessers des Außenleiters zum Außendurchmesser des Innenleiters im Ausgangsabschnitt größer als 1,5, vorzugsweise größer als 2.

Gemäß einer bevorzugten Ausgestaltung der Hochfrequenz-Verstärker-Einheit kann die Hochfrequenz-Verstärker-Einheit eine Ausgangsleistung von mindestens 2 kW, vorzugsweise mindestens 4kW zur Verfügung stellen. Es hat sich gezeigt, dass die beschriebene Hochfrequenz-Verstärker-Einheit bei kompakter Bauform entsprechend hohe Leistungen bereitstellen kann.

Gemäß einem zweiten Aspekt der Erfindung wird die Aufgabe auch durch ein Verstärker-System gelöst, umfassend mehrere Hochfrequenz-Verstärker-Einheiten gemäß dem ersten Aspekt und einen Hochfrequenz-Wellenleiter, wobei die Hochfrequenz-Verstärker-Einheiten entlang der Längsrichtung des Hochfrequenz-Wellenleiters auf dem Hochfrequenz-Wellenleiter angeordnet sind, sodass der Hochfrequenz-Wellenleiter die Ausgangsleistungen der Hochfrequenz-Verstärker-Einheiten zusammenführen kann. Der Hochfrequenz-Wellenleiter ist insbesondere ein Hohlleiter vorzugsweise mit rechteckigem Querschnitt. Beispielsweise werden zumindest zwei, vorzugsweise zumindest vier, weiter vorzugsweise zumindest acht Hochfrequenz-Verstärker-Einheiten auf einer Seite des Hochfrequenz-Wellenleiters angeordnet. Werden die Hochfrequenz-Wellenleiter beidseitig des Hochfrequenz-Wellenleiters angeordnet, kann die Anzahl an Hochfrequenz-Verstärker-Einheiten und damit die Ausgangsleistung verdoppelt werden.

Ein besonders platzsparendes Design ergibt sich, wenn gemäß einer bevorzugten Ausgestaltung des Verstärker-Systems die Längsachsen der Hochfrequenz-Verstärker-Einheiten jeweils quer, insbesondere senkrecht, zu der Längsachse des Hochfrequenz-Wellenleiters liegen.

Besonders vorteilhaft können gemäß einer Ausgestaltung des Verstärker-Systems die koaxialen Innenleiter der Hochfrequenz-Verstärker-Einheiten am ausgangsseitigen Ende jeweils als Sonde (zum Beispiel als (Stab-)Antenne) zum Einkoppeln der Leistung der Koaxial-Combiner in den Hochfrequenz-Wellenleiter dienen.

Durch die beschriebenen Hochfrequenz-Verstärker-Einheiten kann das Verstärker-System eine Ausgangsleistung von beispielsweise zumindest 24 kW, 48 kW oder sogar 96 kW bereitstellen.

Gemäß einer bevorzugten Ausgestaltung des Verstärker-Systems sind die Hochfrequenz-Verstärker-Einheiten in Querrichtung des Hochfrequenz-Wellenleiters versetzt zueinander und/oder beidseitig auf dem Hochfrequenz-Wellenleiter angeordnet. Die Hochfrequenz-Verstärker-Einheiten sind dabei insbesondere im Abstand einer halben (Leiter-)Wellenlänge in Längsrichtung angeordnet. Insbesondere in Kombination mit einem im Wesentlichen quadratischen Querschnitt der Hochfrequenz-Verstärker-Einheiten ergibt sich auf diese Weise ein besonders platzsparendes Design.

Die oben beschriebenen Ausführungsbeispiele und beispielhaften Ausgestaltungen aller Aspekte der vorliegenden Erfindung sollen auch in allen Kombinationen miteinander offenbart verstanden werden. Die obigen Kombinationen sind jedoch nur in der Erfindung enthalten, wenn sie in den Umfang der Ansprüche fallen.

Weitere vorteilhafte beispielhafte Ausgestaltungen der unterschiedlichen Aspekte sind der folgenden detaillierten Beschreibung einiger beispielhafter Ausführungsformen der Aspekte, insbesondere in Verbindung mit den Figuren zu entnehmen. Die der Anmeldung beiliegenden Figuren sollen jedoch nur dem Zwecke der Verdeutlichung, nicht aber zur Bestimmung des Schutzbereiches der Erfindung dienen. Die beiliegenden Zeichnungen sind nicht notwendigerweise maßstabsgetreu und sollen lediglich das allgemeine Konzept der vorliegenden Aspekte beispielhaft widerspiegeln. Insbesondere sollen Merkmale, die in den Figuren enthalten sind, keineswegs als notwendiger Bestandteil der vorliegenden Erfindung erachtet werden.

Es zeigen:
- Fig. 1a,b: ein Ausführungsbeispiel einer erfindungsgemäßen Hochfrequenz-Verstärker-Einheit im Querschnitt und im Längsschnitt;
- Fig. 2: ein weiteres Ausführungsbeispiel einer erfindungsgemäßen Hochfrequenz-Verstärker-Einheit im Längsschnitt;
- Fig. 3: ein weiteres Ausführungsbeispiel einer erfindungsgemäßen Hochfrequenz-Verstärker-Einheit im Querschnitt;
- Fig. 4a,b: ein Ausführungsbeispiel eines erfindungsgemäßen Verstärker-Systems im Querschnitt und in Draufsicht; und
- Fig. 5: ein weiteres Ausführungsbeispiel eines erfindungsgemäßen Verstärker-Systems.

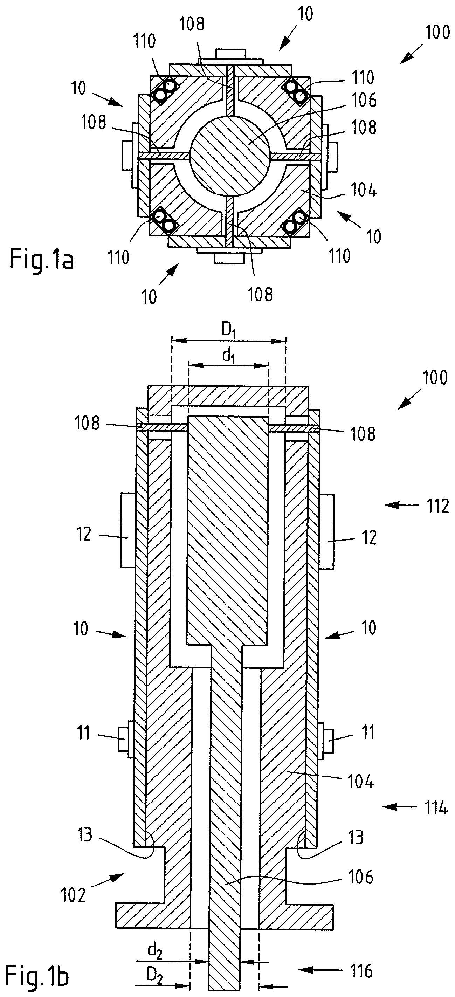

Fig. 1 zeigt zunächst ein Ausführungsbeispiel einer erfindungsgemäßen Hochfrequenz-Verstärker-Einheit 100 im Querschnitt (Fig. 1a) und im Längsschnitt (Fig. 1b). Die Hochfrequenz-Verstärker-Einheit 100 umfasst mehrere (hier vier) Verstärkermodule 10 zum Verstärken von Hochfrequenzeingangssignalen zu Hochfrequenzausgangssignalen. Die Verstärkermodule 10 sind flächig als Platine ausgebildet und umfassen jeweils einen Transistorverstärker 11 und einen Zirkulator 12. Unterseitig weisen die Verstärkermodule 10 eine Metallschicht 13 auf. Die Hochfrequenz-Verstärker-Einheit 100 weist weiterhin einen Koaxial-Combiner 102 mit einem Außenleiter 104 und einem hierzu koaxial angeordneten Innenleiter 106 zum Zusammenführen der Hochfrequenzausgangssignale der Verstärkermodule 10 auf. Der Koaxial-Combiner 102 verläuft in eine Längsrichtung und der Außenleiter 104 ist außenseitig im Querschnitt gesehen quadratisch ausgebildet und bildet somit vier Außenseiten, während der Außenleiter 104 innenseitig und der Innenleiter 106 außenseitig eine kreisförmige Geometrie im Querschnitt aufweisen.

Die Verstärkermodule 10 sind außenseitig flächig auf dem Außenleiter 104 des Koaxial-Combiners 102 angeordnet. Dabei ist auf jeder der vier durch den Außenleiter 104 bereitgestellten Außenflächen ein Verstärkermodul 10 angeordnet. Die Verstärkermodule 10 sind dabei in Umfangsrichtung umlaufend auf dem Außenleiter 104 des Koaxial-Combiners 102 angeordnet.

Die Verstärkermodule 10 sind außerdem derart auf dem Koaxial-Combiner 102 angeordnet, dass der Außenleiter 104 des Koaxial-Combiners 102 im Betrieb zur Kühlung der Verstärkermodule 10 dienen kann. Hierzu ist der Außenleiter 104 des Koaxial-Combiners 102 zur Kühlung der Verstärkermodule 10 als Teil eines Kühlmittelkreislaufs ausgebildet, sodass der Außenleiter über Kühlmittelleitungen 110 mit einem Kühlmittel durströmt werden kann.

Die Verstärkermodule 10 sind zur Übertragung der Hochfrequenzausgangssignale auf den Koaxial-Combiner 102 über Koppelstifte 108 mit dem koaxialen Innenleiter 106 des Koaxial-Combiners 102 verbunden. Dabei sind die vier Verstärkermodule 10 in Längsrichtung gesehen auf gleicher Höhe mit dem koaxialen Innenleiter 106 verbunden.

Der Koaxial-Combiner 102 weist ferner einen Transformatorabschnitt 112 auf. Hierdurch weist der Koaxial-Combiner 102 ein Transformationsverhalten auf, gemäß dem der eingangsseitige Wellenwiderstand am Koaxial-Combiner 102 im Bereich der Koppelstifte 108 auf einen ausgangsseitigen Wellenwiderstand im Bereich des Ausgangsabschnitts 114 am Koaxial-Combiner 102 transformiert wird. Der Transformatorabschnitt 112 stellt in diesem Fall einen λ/4-Transformator dar, an dessen Eingang aufgrund der vier Verstärkermodule 10, welche jeweils einen Leitungswiderstand von 50 Ohm aufweisen, ein Wellenwiderstand von 50 Ohm/4 anliegt. Der Wellenwiderstand des Transformatorabschnitts 112 beträgt hier etwa 25 Ohm, um den Wellenwiderstand an den ausgangsseitigen Wellenwiderstand von 50 Ohm des Ausgangsabschnitts 114 anzupassen.

Hierzu weist in dem Transformatorabschnitt 112 der koaxiale Innenleiter 106 des Koaxial-Combiners 102 einen ersten Außendurchmesser d₁ und der Außenleiter 104 des Koaxial-Combiners 102 einen ersten Innendurchmesser D₁ auf. In dem sich an den Transformatorabschnitt 112 anschließenden Ausgangsabschnitt 114 weist der koaxiale Innenleiter 106 des Koaxial-Combiners 102 einen zweiten Außendurchmesser d₂ und der Außenleiter 104 des Koaxial-Combiners 102 einen zweiten Innendurchmesser D₂ auf. Dabei ist das Verhältnis D₁/d₁ des ersten Innendurchmessers des Außenleiters 104 zum ersten Außendurchmesser des Innenleiters 106 im Transformatorabschnitt 112 kleiner ist als das Verhältnis D₂/d₂ des zweiten Innendurchmessers des Außenleiters 104 zum zweiten Außendurchmesser des Innenleiters 106 im Ausgangsabschnitt 114.

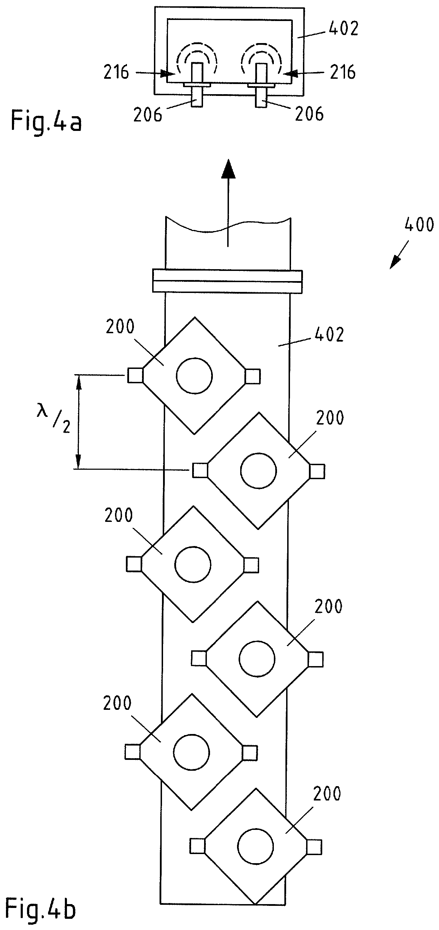

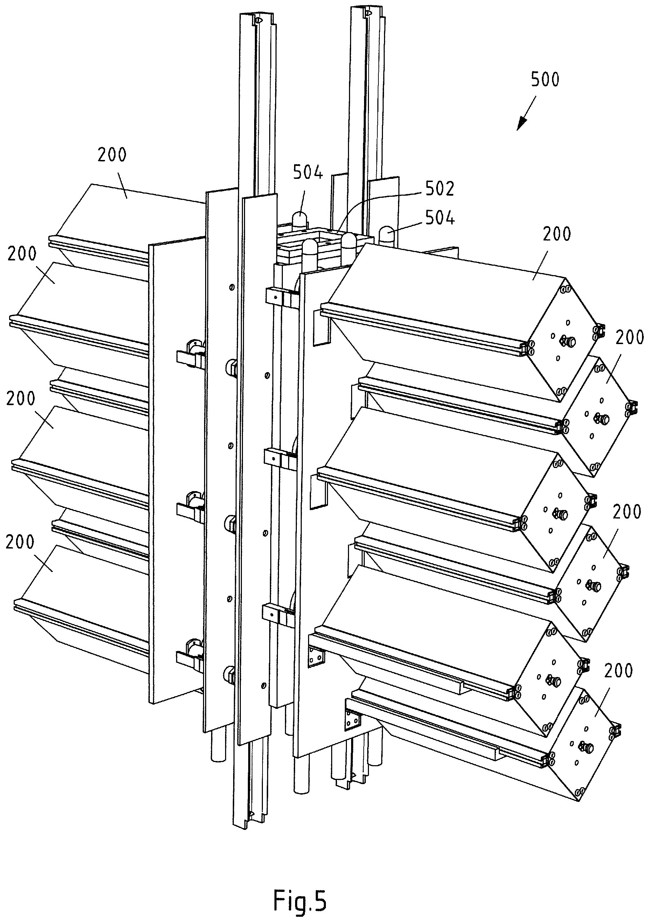

Dadurch, dass der koaxiale Innenleiter 106 ausgangsseitig über den Außenleiter 104 hinausragt, kann dieser als Stabantenne 116 dienen und die Leistung aus der Hochfrequenz-Verstärker-Einheit 100 auskoppeln bzw. in einen Hochfrequenz-Wellenleiter einkoppeln (siehe Fig. 4 oder 5).

Im vorliegenden Beispiel stellen die einzelnen Verstärkermodule 10 eine Leistung von etwa 500 W zur Verfügung, sodass die Hochfrequenz-Verstärker-Einheit 100 eine Ausgangsleistung von etwa 2 kW im Betrieb zur Verfügung stellen kann.

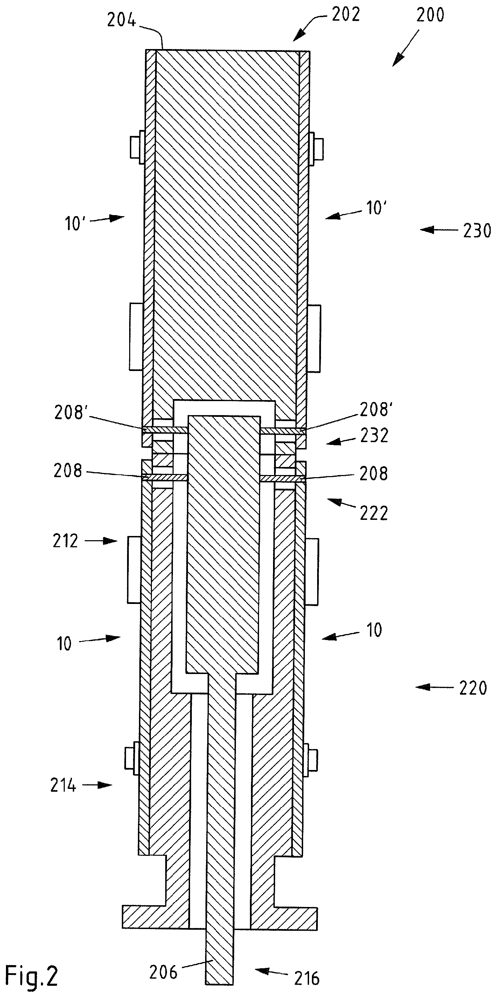

Fig. 2 zeigt ein weiteres Ausführungsbeispiel einer erfindungsgemäßen Hochfrequenz-Verstärker-Einheit 200 im Längsschnitt. Die Hochfrequenz-Verstärker-Einheit 200 ist ähnlich zu der Hochfrequenz-Verstärker-Einheit 100 aufgebaut, sodass zunächst auf Fig. 1 verwiesen wird. Im Folgenden soll insbesondere auf die Unterschiede eingegangen werden, wobei entsprechende Bezugszeichen 200 anstatt 100 verwendet werden.

So weist die Hochfrequenz-Verstärker-Einheit 200 einen in Längsrichtung längeren Koaxial-Combiner 202 mit einem insbesondere längeren Außenleiter 204 auf. Dadurch können nicht nur (in diesem Fall vier) Verstärkermodule 10 einer ersten (untere) Gruppe von Verstärkermodulen 10 in einem ersten Längsabschnitt 220 des Koaxial-Combiners 202 außenseitig auf dem Außenleiter 204 des Koaxial-Combiners 202 angeordnet werden, sondern zudem (in diesem Fall vier) weitere Verstärkermodule 10' einer zweiten (obere) Gruppe von Verstärkermodulen 10' in einem zweiten Längsabschnitt 230 des Koaxial-Combiners 202 außenseitig auf dem Außenleiter 204 des Koaxial-Combiners 202 angeordnet werden. Auf diese Weise wird die Ausgangsleistung des Koaxial-Combiners 202 verdoppelt.

Dabei sind die Verstärkermodule 10 der ersten (unteren) Gruppe an einem dem zweiten Längsabschnitt 230 des Koaxial-Combiners 202 zugewandten Endbereich 222 des ersten Längsabschnitts 220 des Koaxial-Combiners 202 mit dem koaxialen Innenleiter 206 verbunden. Die Verstärkermodule 10' der zweiten (oberen) Gruppe sind an einem dem ersten Längsabschnitt 220 des Koaxial-Combiners 202 zugewandten Endbereich 232 des zweiten Längsabschnitts 230 des Koaxial-Combiners 202 mit dem koaxialen Innenleiter 206 verbunden. Hierzu erstreckt sich der koaxiale Innenleiter 206 in den dem ersten Längsabschnitt 220 des Koaxial-Combiners 202 zugewandten Endbereich 232 des zweiten Längsabschnitts 230 des Koaxial-Combiners 202. Im Übrigen ist der zweite Längsabschnitt 230 des Koaxial-Combiners 202 nach einem Luftspalt nach dem Ende des Innenleiters 206 mit einem massiv weitergeführten Außenleiter 204 ausgebildet, damit sich das Hochfrequenzfeld nicht entgegen der gewünschten Richtung nach oben in den und aus dem Koaxial-Combiner 202 heraus erstreckt. Alternativ wäre es aber auch bereits ausreichend, eine Wand (Leiterplatte) als Abschluss vorzusehen.

Wie auch beim Koaxial-Combiner 102 sind die Verstärkermodule 10 der ersten Gruppe in Längsrichtung des Koaxial-Combiners 202 gesehen mittels der Koppelstifte 208 jeweils auf gleicher Höhe mit dem koaxialen Innenleiter 206 verbunden. Ebenso sind die Verstärkermodule 10' der zweiten Gruppe in Längsrichtung des Koaxial-Combiners 202 gesehen mittels der Koppelstifte 208' jeweils auf gleicher Höhe mit dem koaxialen Innenleiter 206 verbunden, welcher sich in den zweiten Längsabschnitt 230 erstreckt.

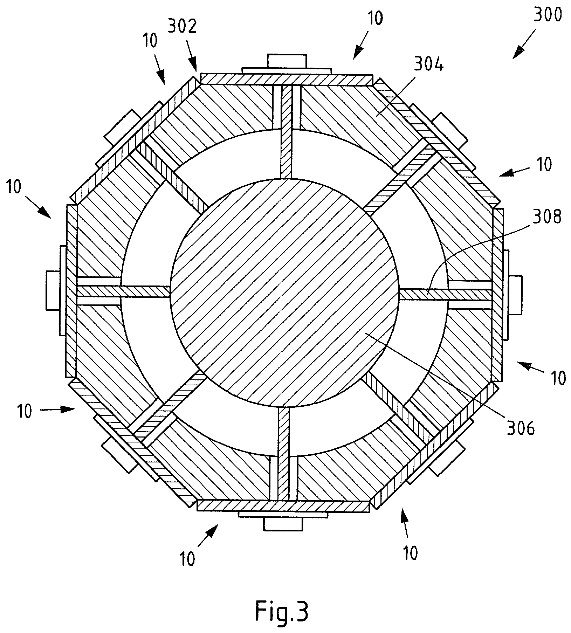

Fig. 3 zeigt ein weiteres Ausführungsbeispiel einer erfindungsgemäßen Hochfrequenz-Verstärker-Einheit 300 im Querschnitt. Im Längsschnitt gesehen kann die Hochfrequenz-Verstärker-Einheit 300 so aufgebaut sein, wie die in Fig. 1b oder Fig. 2 gezeigten Hochfrequenz-Verstärker-Einheiten 100, 200. Im Unterschied zu diesen Ausführungsbeispielen ist der Außenleiter 304 des Koaxial-Combiners 302 außenseitig in diesem Fall im Querschnitt jedoch nicht viereckig, sondern achteckig ausgebildet. Dadurch können acht Verstärkermodule 10 außenseitig auf dem Außenleiter 304 flächig angeordnet werden. Ebenfalls ist eine der Anzahl der Verstärkermodule 10 entsprechende Anzahl von radial einwärts verlaufenden Koppelstiften 308 zur Verbindung der Verstärkermodule 10 mit dem Innenleiter 306 vorgesehen. Wie der Innenleiter 306 ist der Außenleiter 304 des Koaxial-Combiners 302 wieder rund bzw. kreisförmig ausgebildet.

Fig. 4 zeigt ein Ausführungsbeispiel eines erfindungsgemäßen Verstärker-Systems 400 im Querschnitt (Fig. 4a) und in Draufsicht (Fig. 4b). Das Verstärker-System 400 umfasst mehrere der Hochfrequenz-Verstärker-Einheiten 200 aus Fig. 2. Allerdings können ebenfalls die Hochfrequenz-Verstärker-Einheiten 100 aus Fig. 1 oder die Hochfrequenz-Verstärker-Einheiten 300 aus Fig. 3 vorgesehen werden. Weiterhin umfasst das Verstärker-System 400 einen Hochfrequenz-Wellenleiter 402 mit rechteckigem Querschnitt. Die Hochfrequenz-Verstärker- Einheiten 200 sind entlang der Längsrichtung des Hochfrequenz-Wellenleiters 402 auf dem Hochfrequenz-Wellenleiter 402 angeordnet. Dabei liegen die Längsachsen der Hochfrequenz-Verstärker-Einheiten 200 jeweils senkrecht zu der Längsachse des Hochfrequenz-Wellenleiters 402. Die Hochfrequenz-Verstärker-Einheiten 200 sind zudem in Querrichtung des Hochfrequenz-Wellenleiters 402 versetzt zu der Mittelachse des Hochfrequenz-Wellenleiters 402 und abwechselnd versetzt zueinander und in Längsrichtung im Abstand einer halben Wellenlänge auf dem Hochfrequenz-Wellenleiter 402 angeordnet. Alternativ können die Hochfrequenz-Verstärker-Einheiten 200 aber auch nur mittig auf der Mittelachse des Hochfrequenz-Wellenleiters 402 angeordnet werden. Ebenfalls können die Hochfrequenz-Verstärker-Einheiten 200 auch in Querrichtung versetzt zur Mittelachse aber in Zweierpaaren in Längsrichtung gesehen auf gleicher Höhe angeordnet sein. Auch können die Hochfrequenz-Verstärker-Einheiten 200 auf beiden gegenüberliegenden Seitenwänden (in Fig. 4b ist nur von die Vorderseite des Hochfrequenz-Wellenleiters 402 zu sehen) angeordnet werden. Auch Kombinationen der genannten Möglichkeiten sind denkbar. Wie zu erkennen ist, führt insbesondere das rechteckige bzw. quadratische Design der Koaxial-Combiner 202 zu einer kompakten Bauform.

Die Ausgangsleistungen der Hochfrequenz-Verstärker-Einheiten 200 werden durch den Hochfrequenz-Wellenleiter 402 zusammengeführt. Wie in Fig. 4a (welche lediglich den Bereich des Hochfrequenz-Wellenleiters darstellt) zu sehen, ragen die koaxialen Innenleiter 206 ausgangsseitig in den Hochfrequenz-Wellenleiter 402 hinein. Dadurch dienen die koaxialen Innenleiter 206 der Hochfrequenz-Verstärker-Einheiten 200 am ausgangsseitigen Ende jeweils als Sonde in Form einer Stabantenne 216 zum Einkoppeln der Leistung der Koaxial-Combiner 202 in den Hochfrequenz-Wellenleiter 402.

Geht man von einer Ausgangsleistung der einzelnen Hochfrequenz-Verstärker-Einheiten 200 von 8 x 500 W = 4kW aus, kann das Verstärker-System eine Ausgangsleistung von 24 kW liefern.

Fig. 5 zeigt ein weiteres Ausführungsbeispiel eines erfindungsgemäßen Verstärker-Systems 500, welches ähnlich zu dem bereits in Fig. 4 dargestellten Verstärker-System 400 ist. Auch hier sind die Hochfrequenz-Verstärker-Einheiten 200 auf einem Hochfrequenz-Wellenleiter 502 angeordnet, wobei auch hier grundsätzlich andere Hochfrequenz-Verstärker-Einheiten 200 verwendet werden können. Im Unterschied zu dem in Fig. 4 dargestellten System 400 sind die Hochfrequenz-Verstärker-Einheiten 200 beidseitig auf dem Hochfrequenz-Wellenleiter 502 angeordnet. Dadurch ergibt sich eine im Vergleich zum Verstärker-System 400 verdoppelte Ausgangsleistung von 48 kW. Ebenfalls zu erkennen sind Kühlmittelleitungen 504, welche ein Kühlmittel zu den Hochfrequenz-Verstärker-Einheiten 200 transportieren, sodass die Außenleiter 204 der Koaxial-Combiner 202 mit dem Kühlmittel durchströmt werden können und die Abwärme der Verstärkermodule 10, 10' abführen können, ohne das es weiterer Kühleinrichtungen zwischen Verstärkermodulen 10, 10' und dem Koaxial-Combiner 202 bedarf.

## Patentansprüche

1. Hochfrequenz-Verstärker-Einheit (100, 200, 300) umfassend
- mehrere Verstärkermodule (10, 10') zum Verstärken von Hochfrequenzeingangssignalen zu Hochfrequenzausgangssignalen und
- einen Koaxial-Combiner (102, 202, 302) mit einem Außenleiter (104, 204, 304) und einem hierzu koaxial angeordneten Innenleiter (106, 206, 306) zum Zusammenführen der Hochfrequenzausgangssignale der Verstärkermodule (10, 10'),
- die Verstärkermodule (10,10') außenseitig auf dem Außenleiter (104, 204, 304) des Koaxial-Combiners (102, 202, 302) angeordnet sind,
- die Verstärkermodule (10,10') zur Übertragung der Hochfrequenzausgangssignale auf den Koaxial-Combiner (102, 202, 302) mit dem koaxialen Innenleiter (106, 206, 306) des Koaxial-Combiners (102, 202,302) verbunden sind,
**dadurch gekennzeichnet, dass**
- die Verstärkermodule (10, 10') im Wesentlichen flächig ausgebildet sind und im Wesentlichen flächig auf dem Außenleiter (104, 204, 304) des Koaxial-Combiners (102, 202, 302) angeordnet sind, und
- die Verstärkermodule (10, 10') derart außenseitig auf dem Koaxial-Combiner (102, 202, 302) angeordnet sind, dass der Außenleiter (104, 204, 304) des Koaxial-Combiners (102, 202, 302) zur Kühlung der Verstärkermodule (10, 10') dienen kann.

2. Hochfrequenz-Verstärker-Einheit nach Anspruch 1,
**dadurch gekennzeichnet, dass**
der Koaxial-Combiner (102, 202, 302) in eine Längsrichtung verläuft und der Außenleiter (104, 204, 304) außenseitig im Querschnitt mehreckig, insbesondere viereckig ausgebildet ist.

3. Hochfrequenz-Verstärker-Einheit nach einem der vorhergehenden Ansprüche, **dadurch gekennzeichnet, dass**
der Außenleiter (104, 204, 304) des Koaxial-Combiners (102, 202, 302) zur Kühlung der Verstärkermodule (10, 10') als Teil eines Kühlmittelkreislaufs ausgebildet ist.

4. Hochfrequenz-Verstärker-Einheit nach einem der vorhergehenden Ansprüche, **dadurch gekennzeichnet, dass**
die Verstärkermodule (10, 10') umlaufend auf dem Außenleiter (104, 204, 304) des Koaxial-Combiners (102, 202, 302) angeordnet sind.

5. Hochfrequenz-Verstärker-Einheit nach einem der vorhergehenden Ansprüche, **dadurch gekennzeichnet, dass**
zumindest ein Teil der Verstärkermodule (10, 10') in Längsrichtung gesehen auf gleicher Höhe mit dem koaxialen Innenleiter (106, 206, 306) verbunden ist.

6. Hochfrequenz-Verstärker-Einheit nach einem der vorhergehenden Ansprüche, **dadurch gekennzeichnet, dass**
Verstärkermodule (10, 10') einer ersten Gruppe von Verstärkermodulen (10, 10') in einem ersten Längsabschnitt (220) des Koaxial-Combiners (102, 202, 302) außenseitig auf dem Außenleiter (104, 204, 304) des Koaxial-Combiners (102, 202, 302) angeordnet sind und Verstärkermodule (10, 10') einer zweiten Gruppe von Verstärkermodulen (10, 10') in einem zweiten Längsabschnitt (230) des Koaxial-Combiners (102, 202, 302) außenseitig auf dem Außenleiter (104, 204, 304) des Koaxial-Combiners (102, 202, 302) angeordnet sind.

7. Hochfrequenz-Verstärker-Einheit nach dem vorhergehenden Anspruch,
**dadurch gekennzeichnet, dass**
die Verstärkermodule (10, 10') der ersten Gruppe an einem dem zweiten Längsabschnitt (230) des Koaxial-Combiners (102, 202, 302) zugewandten Endbereich (222) des ersten Längsabschnitts (220) des Koaxial-Combiners (102, 202, 302) mit dem koaxialen Innenleiter (106, 206, 306) verbunden sind und/oder
die Verstärkermodule (10, 10') der zweiten Gruppe an einem dem ersten Längsabschnitt (220) des Koaxial-Combiners (102, 202, 302) zugewandten Endbereich (232) des zweiten Längsabschnitts (230) des Koaxial-Combiners (102, 202, 302) mit dem koaxialen Innenleiter (106, 206, 306) verbunden sind.

8. Hochfrequenz-Verstärker-Einheit nach einem der Ansprüche 6 oder 7,
**dadurch gekennzeichnet, dass**
sich der koaxiale Innenleiter (106, 206, 306) in den dem ersten Längsabschnitt (220) des Koaxial-Combiners (102, 202, 302) zugewandten Endbereich (232) des zweiten Längsabschnitts (230) des Koaxial-Combiners (102, 202, 302) erstreckt.

9. Hochfrequenz-Verstärker-Einheit nach einem der Ansprüche 6 bis 8,
**dadurch gekennzeichnet, dass**
die Verstärkermodule (10, 10') der ersten Gruppe und die Verstärkermodule (10, 10') der zweiten Gruppe in Längsrichtung des Koaxial-Combiners (102, 202, 302) gesehen jeweils auf gleicher Höhe mit dem koaxialen Innenleiter (106, 206, 306) verbunden sind.

10. Hochfrequenz-Verstärker-Einheit nach einem der vorhergehenden Ansprüche, **dadurch gekennzeichnet, dass**
der Koaxial-Combiner (102, 202, 302) einen Transformatorabschnitt (112, 212) mit einem Transformationsverhalten aufweist, sodass der eingangsseitige Wellenwiderstand am Koaxial-Combiner (102, 202, 302) auf einen ausgangsseitigen Wellenwiderstand am Koaxial-Combiner (102, 202, 302) transformiert wird.

11. Hochfrequenz-Verstärker-Einheit nach dem vorhergehenden Anspruch,
**dadurch gekennzeichnet, dass**
in dem Transformatorabschnitt (112, 212) der koaxiale Innenleiter (106, 206, 306) des Koaxial-Combiners (102, 202, 302) einen ersten Außendurchmesser (d₁) und der Außenleiter (104, 204, 304) des Koaxial-Combiners (102, 202, 302) einen ersten Innendurchmesser (D₁) aufweist und dass in einem sich an den Transformatorabschnitt (112, 212) anschließenden Ausgangsabschnitt (114, 214) der koaxiale Innenleiter (106, 206, 306) des Koaxial-Combiners (102, 202, 302) einen zweiten Außendurchmesser (d₂) und der Außenleiter (104, 204, 304) des Koaxial-Combiners (102, 202, 302) einen zweiten Innendurchmesser (D₂) aufweist.

12. Hochfrequenz-Verstärker-Einheit nach dem vorhergehenden Anspruch,
**dadurch gekennzeichnet, dass**
das Verhältnis des ersten Innendurchmessers (D₁) des Außenleiters (104, 204, 304) zum ersten Außendurchmesser (d₁) des Innenleiters (106, 206, 306) im Transformatorabschnitt (112, 212) kleiner ist als das Verhältnis des zweiten Innendurchmessers (D₂) des Außenleiters (104, 204, 304) zum zweiten Außendurchmesser (d₂) des Innenleiters (106, 206, 306) im Ausgangsabschnitt (114, 214).

13. Hochfrequenz-Verstärker-Einheit nach einem der vorhergehenden Ansprüche, **dadurch gekennzeichnet, dass**
die Hochfrequenz-Verstärker-Einheit (100, 200, 300) eine Ausgangsleistung von mindestens 2 kW, vorzugsweise mindestens 4kW zur Verfügung stellen kann.

14. Verstärker-System umfassend
- mehrere Hochfrequenz-Verstärker-Einheiten (100, 200, 300) nach einem der vorhergehenden Ansprüche und
- einen Hochfrequenz-Wellenleiter (402, 502),
wobei die Hochfrequenz-Verstärker-Einheiten (100, 200, 300) entlang der Längsrichtung des Hochfrequenz-Wellenleiters (402, 502) auf dem Hochfrequenz-Wellenleiter (402, 502) angeordnet sind, sodass der Hochfrequenz-Wellenleiter (402, 502) die Ausgangsleistungen der Hochfrequenz-Verstärker-Einheiten (100, 200, 300) zusammenführen kann.

15. Verstärker-System nach Anspruch 14,
**dadurch gekennzeichnet, dass**
die Längsachsen der Hochfrequenz-Verstärker-Einheiten (100, 200, 300) jeweils quer, insbesondere senkrecht, zu der Längsachse des Hochfrequenz-Wellenleiters (402, 502) liegen.

16. Verstärker-System nach Anspruch 14 oder 15,
**dadurch gekennzeichnet, dass**
die koaxialen Innenleiter (106, 206, 306) der Hochfrequenz-Verstärker-Einheiten (100, 200, 300) am ausgangsseitigen Ende jeweils als Sonde (116, 216) zum Einkoppeln der Leistung der Koaxial-Combiner (102, 202, 302) in den Hochfrequenz-Wellenleiter (402, 502) dienen.

17. Verstärker-System nach einem der Ansprüche 14 bis 16,
**dadurch gekennzeichnet, dass**
die Hochfrequenz-Verstärker-Einheiten (100, 200, 300) in Querrichtung des Hochfrequenz-Wellenleiters (402, 502) versetzt zueinander und/oder beidseitig auf dem Hochfrequenz-Wellenleiter (402, 502) angeordnet sind.

## Claims

1. High-frequency amplifier unit (100, 200, 300) comprising
- a plurality of amplifier modules (10, 10') for amplifying high-frequency input signals to high-frequency output signals, and
- a coaxial combiner (102, 202, 302) with an outer conductor (104, 204, 304) and an inner conductor (106, 206, 306) arranged coaxially thereto for combining the high-frequency output signals of the amplifier modules (10, 10'),
- the amplifier modules (10, 10') being arranged on the outside on the outer conductor (104, 204, 304) of the coaxial combiner (102, 202, 302),
- the amplifier modules (10, 10') are connected to the coaxial inner conductor (106, 206, 306) of the coaxial combiner (102, 202, 302) for transferring the high-frequency output signals to the coaxial combiner (102, 202, 302),
**characterized in that**
- the amplifier modules (10, 10') are essentially flat in design and are arranged essentially flat on the outer conductor (104, 204, 304) of the coaxial combiner (102, 202, 302), and
- the amplifier modules (10, 10') are arranged on the outside of the coaxial combiner (102, 202, 302) in such a way that the outer conductor (104, 204, 304) of the coaxial combiner (102, 202, 302) can serve to cool the amplifier modules (10, 10').

2. High-frequency amplifier unit according to claim 1,
**characterized in that**
the coaxial combiner (102, 202, 302) extends in a longitudinal direction and the outer conductor (104, 204, 304) is polygonal, in particular quadrangular, in cross-section on the outside.

3. High-frequency amplifier unit according to one of the preceding claims,
**characterized in that**
the outer conductor (104, 204, 304) of the coaxial combiner (102, 202, 302) is designed as part of a coolant circuit for cooling the amplifier modules (10, 10').

4. High-frequency amplifier unit according to one of the preceding claims,
**characterized in that**
the amplifier modules (10, 10') are arranged circumferentially on the outer conductor (104, 204, 304) of the coaxial combiner (102, 202, 302).

5. High-frequency amplifier unit according to one of the preceding claims,
**characterized in that**
at least some of the amplifier modules (10, 10') are connected at the same height as the coaxial inner conductor (106, 206, 306) when viewed in the longitudinal direction.

6. High-frequency amplifier unit according to one of the preceding claims,
**characterized in that**
amplifier modules (10, 10') of a first group of amplifier modules (10, 10') are arranged in a first longitudinal section (220) of the coaxial combiner (102, 202, 302) on the outside to the outer conductor (104, 204, 304) of the coaxial combiner (102, 202, 302) and amplifier modules (10, 10') of a second group of amplifier modules (10, 10') are arranged in a second longitudinal section (230) of the coaxial combiner (102, 202, 302) on the outside of the outer conductor (104, 204, 304) of the coaxial combiner (102, 202, 302).

7. High-frequency amplifier unit according to the preceding claim,
**characterized in that**
the amplifier modules (10, 10') of the first group are connected to the coaxial inner conductor (106, 206, 306) at an end region (222) of the first longitudinal section (220) of the coaxial combiner (102, 202, 302) facing the second longitudinal section (230) of the coaxial combiner (102, 202, 302) 302) and/or the amplifier modules (10, 10') of the second group are connected to the coaxial inner conductor (106, 206, 306) at an end region (232) of the second longitudinal section (230) of the coaxial combiner (102, 202, 302) facing the first longitudinal section (220) of the coaxial combiner (102, 202, 302).

8. High-frequency amplifier unit according to one of claims 6 or 7,
**characterized in that**
the coaxial inner conductor (106, 206, 306) extends into the end region (232) of the second longitudinal section (230) of the coaxial combiner (102, 202, 302) facing the first longitudinal section (220) of the coaxial combiner (102, 202, 302).

9. High-frequency amplifier unit according to one of claims 6 to 8,
**characterized in that**
the amplifier modules (10, 10') of the first group and the amplifier modules (10, 10') of the second group are connected, as seen in the longitudinal direction of the coaxial combiner (102, 202, 302), at the same height as the coaxial inner conductor (106, 206, 306).

10. High-frequency amplifier unit according to one of the preceding claims,
**characterized in that**
the coaxial combiner (102, 202, 302) has a transformer section (112, 212) with a transformation behavior such that the input-side characteristic impedance at the coaxial combiner (102, 202, 302) is transformed to an output-side characteristic impedance at the coaxial combiner (102, 202, 302).

11. High-frequency amplifier unit according to the preceding claim,
**characterized in that**
in the transformer section (112, 212), the coaxial inner conductor (106, 206, 306) of the coaxial combiner (102, 202, 302) has a first outer diameter (d₁) and the outer conductor (104, 204, 304) of the coaxial combiner (102, 202, 302) has a first inner diameter (D₁) and that in an output section (114, 214) adjoining the transformer section (112, 212), the coaxial inner conductor (106, 206, 306) of the coaxial combiner (102, 202, 302) has a second outer diameter (d₂) and the outer conductor (104, 204, 304) of the coaxial combiner (102, 202, 302) has a second inner diameter (D₂).

12. High-frequency amplifier unit according to the preceding claim,
**characterized in that**
the ratio of the first inner diameter (D₁) of the outer conductor (104, 204, 304) to the first outer diameter (d₁) of the inner conductor (106, 206, 306) in the transformer section (112, 212) is smaller than the ratio of the second inner diameter (D₂) of the outer conductor (104, 204, 304) to the second outer diameter (d₂) of the inner conductor (106, 206, 306) in the output section (114, 214).

13. High-frequency amplifier unit according to one of the preceding claims,
**characterized in that**
the high-frequency amplifier unit (100, 200, 300) can provide an output power of at least 2 kW, preferably at least 4 kW.

14. Amplifier system comprising
- a plurality of high-frequency amplifier units (100, 200, 300) according to one of the preceding claims and
- a high-frequency waveguide (402, 502),
wherein the high-frequency amplifier units (100, 200, 300) are arranged along the longitudinal direction of the high-frequency waveguide (402, 502) on the high-frequency waveguide (402, 502) so that the high-frequency waveguide (402, 502) can combine the output powers of the high-frequency amplifier units (100, 200, 300).

15. Amplifier system according to claim 14,
**characterized in that**
the longitudinal axes of the high-frequency amplifier units (100, 200, 300) are each transverse, in particular perpendicular, to the longitudinal axis of the high-frequency waveguide (402, 502).

16. Amplifier system according to claim 14 or 15,
**characterized in that**
the coaxial inner conductors (106, 206, 306) of the high-frequency amplifier units (100, 200, 300) serve at the output end as probes (116, 216) for coupling the power of the coaxial combiners (102, 202, 302) into the high-frequency waveguide (402, 502).

17. Amplifier system according to one of claims 14 to 16,
**characterized in that**
the high-frequency amplifier units (100, 200, 300) are arranged offset from one another in the transverse direction of the high-frequency waveguide (402, 502) and/or on both sides of the high-frequency waveguide (402, 502).

## Revendications

1. Bloc amplificateur de haute fréquence (100, 200, 300) comprenant :
- plusieurs modules amplificateurs (10, 10') pour amplifier des signaux d'entrée à haute fréquence en signaux de sortie à haute fréquence et
- un combineur coaxial (102, 202, 302) ayant un conducteur extérieur (104, 204, 304) et un conducteur intérieur (106, 206, 306) disposé coaxialement à celui-ci pour combiner les signaux de sortie à haute fréquence des modules amplificateurs (10, 10'),
- les modules amplificateurs (10, 10') sont disposés sur le côté extérieur du conducteur extérieur (104, 204, 304) du combineur coaxial (102, 202, 302),
- les modules amplificateurs (10, 10') sont connectés au conducteur intérieur coaxial (106, 206, 306) du combineur coaxial (102, 202, 302) pour transmettre les signaux de sortie à haute fréquence au combineur coaxial (102, 202, 302),
**caractérisé en ce que**
- les modules amplificateurs (10, 10') sont formés de manière sensiblement plate et sont disposés pratiquement à plat sur le conducteur extérieur (104, 204, 304) du combineur coaxial (102, 202, 302), et
- les modules amplificateurs (10, 10') sont disposés sur le côté extérieur du combineur coaxial (102, 202, 302) de telle sorte que le conducteur extérieur (104, 204, 304) du combineur coaxial (102, 202, 302) peut servir à refroidir les modules amplificateurs (10, 10').

2. Bloc amplificateur de haute fréquence selon la revendication 1,
**caractérisé en ce que**
le combineur coaxial (102, 202, 302) s'étend dans une direction longitudinale et le conducteur extérieur (104, 204, 304) est formé de manière polygonale, en particulier quadrangulaire, en section transversale sur le côté extérieur.

3. Bloc amplificateur de haute fréquence selon l'une des revendications précédentes,
**caractérisé en ce que**
le conducteur extérieur (104, 204, 304) du combineur coaxial (102, 202, 302) est formé comme une partie d'un circuit de fluide de refroidissement, afin de refroidir les modules amplificateurs (10, 10').

4. Bloc amplificateur de haute fréquence selon l'une des revendications précédentes,
**caractérisé en ce que**
les modules amplificateurs (10, 10') sont disposés de manière circonférentielle sur le conducteur extérieur (104, 204, 304) du combineur coaxial (102, 202, 302).

5. Bloc amplificateur de haute fréquence selon l'une des revendications précédentes,
**caractérisé en ce que**
au moins une partie des modules amplificateurs (10,10'), lorsqu'ils sont vus dans la direction longitudinale, est connectée au conducteur intérieur coaxial (106, 206, 306), à la même hauteur.

6. Bloc amplificateur de haute fréquence selon l'une des revendications précédentes,
**caractérisé en ce que**
des modules amplificateurs (10, 10') d'un premier groupe de modules amplificateurs (10, 10') dans une première section longitudinale (220) du combineur axial (102, 202, 302) sont disposés sur le côté extérieur du conducteur extérieur (104, 204, 304) du combineur coaxial (102, 202, 302), et des modules amplificateurs (10, 10') d'un second groupe de modules amplificateurs (10, 10') dans une seconde section longitudinale (230) du combineur coaxial (102, 202, 302) sont disposés sur le côté extérieur du conducteur extérieur (104, 204, 304) du combineur coaxial (102, 202, 302).

7. Bloc amplificateur de haute fréquence selon la revendication précédente,
**caractérisé en ce que**
les modules amplificateurs (10, 10') du premier groupe au niveau d'une zone d'extrémité (222) de la première section longitudinale (220) du combineur coaxial (102, 202, 302) dirigée vers la seconde section longitudinale (230) du combineur coaxial (102, 202, 302) sont connectés au conducteur intérieur coaxial (106, 206, 306) et/ou
les modules amplificateurs (10, 10') du second groupe au niveau d'une zone d'extrémité (232) de la seconde section longitudinale (230) du combineur coaxial (102, 202, 302) dirigée vers la première section longitudinale (220) du combineur coaxial (102, 202, 302) sont connectés au conducteur intérieur coaxial (106, 206, 306).

8. Bloc amplificateur de haute fréquence selon l'une des revendications 6 ou 7,
**caractérisé en ce que**
le conducteur intérieur coaxial (106, 206, 306) s'étend dans la zone d'extrémité (232) de la seconde section longitudinale (230) du combineur coaxial (102, 202, 302) dirigée vers la première section longitudinale (220) du combineur coaxial (102, 202, 302).

9. Bloc amplificateur de haute fréquence selon l'une des revendications 6 à 8,
**caractérisé en ce que**
les modules amplificateurs (10, 10') du premier groupe et les modules amplificateurs (10, 10') du second groupe, lorsqu'ils sont vus dans la direction longitudinale du combineur coaxial (102, 202, 302), sont respectivement connectés au conducteur intérieur coaxial (106, 206, 306), à la même hauteur.

10. Bloc amplificateur de haute fréquence selon l'une des revendications précédentes,
**caractérisé en ce que**
le combineur coaxial (102, 202, 302) comporte une section de transformateur (112, 212) avec un comportement de transformation, de telle sorte que l'impédance d'onde côté entrée sur le combineur coaxial (102, 202, 302) est transformée en une impédance d'onde côté sortie sur le combineur coaxial (102, 202, 302).

11. Bloc amplificateur de haute fréquence selon la revendication précédente,
**caractérisé en ce que**
dans la section de transformateur (112, 212), le conducteur intérieur coaxial (106, 206, 306) du combineur coaxial (102, 202, 302) a un premier diamètre extérieur (d₁) et le conducteur extérieur (104, 204, 304) du combineur coaxial (102, 202, 302) a un premier diamètre intérieur (D₁), et **en ce que** dans une section de sortie (114, 214) connectée à la section de transformateur (112, 212), le conducteur intérieur coaxial (106, 206, 306) du combineur coaxial (106, 206, 306) a un second diamètre extérieur (d₂) et le conducteur extérieur (104, 204, 304) du combineur coaxial (102, 202, 302) a un second diamètre intérieur (D₂).

12. Bloc amplificateur de haute fréquence selon la revendication précédente,
**caractérisé en ce que**
le rapport du premier diamètre intérieur (D₁) du conducteur extérieur (104, 204, 304) sur le premier diamètre extérieur (d₁) du conducteur intérieur (206, 206, 306) dans la section de transformateur (112, 212) est inférieur au rapport du second diamètre intérieur (D₂) du conducteur extérieur (104, 204, 304) sur le second diamètre extérieur (d₂) du conducteur intérieur (106, 206, 306) dans la section de sortie (114, 214).

13. Bloc amplificateur de haute fréquence selon l'une des revendications précédentes,
**caractérisé en ce que**
le bloc amplificateur de haute fréquence (100, 200, 300) peut fournir une puissance de sortie d'au moins 2 kW, de préférence d'au moins 4 kW.

14. Système amplificateur comprenant :
- plusieurs blocs amplificateurs de haute fréquence (100, 200, 300) selon l'une des revendications précédentes et
- un guide d'ondes à haute fréquence (402, 502),
dans lequel les blocs amplificateurs de haute fréquence (100, 200, 300) sont disposés sur le guide d'ondes à haute fréquence (402, 502) le long de la direction longitudinale du guide d'ondes à haute fréquence (402, 502), de telle sorte que le guide d'ondes à haute fréquence (402, 502) peut combiner les puissances de sortie des blocs amplificateurs de haute fréquence (100, 200, 300).

15. Système amplificateur selon la revendication 14,
**caractérisé en ce que**
les axes longitudinaux des blocs amplificateurs de haute fréquence (100, 200, 300) sont respectivement transversaux, en particulier orthogonaux, à l'axe longitudinal du guide d'ondes à haute fréquence (402, 502).

16. Système amplificateur selon la revendication 14 ou 15,
**caractérisé en ce que**
les conducteurs intérieurs coaxiaux (106, 206, 306) des blocs amplificateurs de haute fréquence (100, 200, 300) sur l'extrémité côté sortie servent respectivement de sonde (116, 216) pour coupler la puissance des combineurs coaxiaux (102, 202, 302) dans le guide d'ondes à haute fréquence (402, 502).

17. Système amplificateur selon l'une des revendications 14 à 16,
**caractérisé en ce que**
les blocs amplificateurs de haute fréquence (100, 200, 300) sont décalés les uns des autres dans une direction transversale du guide d'ondes à haute fréquence (402, 502) et/ou sont disposés des deux côtés du guide d'ondes à haute fréquence (402, 502).
